Europäisches Patentamt

European Patent Office

Office européen des brevets

(19)

(11) **EP 0 674 778 B1**

(12) **EUROPÄISCHE PATENTSCHRIFT**

(45) Veröffentlichungstag und Bekanntmachung des Hinweises auf die Patenterteilung:
**28.07.2004 Patentblatt 2004/31**

(21) Anmeldenummer: **94929516.6**

(22) Anmeldetag: **06.10.1994**

(51) Int Cl.⁷: $G03F\ 7/20$, $G03F\ 7/00$

(86) Internationale Anmeldenummer:
**PCT/EP1994/003306**

(87) Internationale Veröffentlichungsnummer:
**WO 1995/010799 (20.04.1995 Gazette 1995/17)**

(54) **VERFAHREN UND ANORDNUNG ZUR ERZEUGUNG VON DOSISPROFILEN FÜR DIE HERSTELLUNG STRUKTURIERTER OBERFLÄCHEN**

PROCESS AND DEVICE FOR GENERATING DOSAGE PATTERNS FOR THE PRODUCTION OF STRUCTURED SURFACES

PROCEDE ET DISPOSITIF POUR GENERER DES PROFILS DE DOSE DE RAYONNEMENT POUR LA REALISATION DE SURFACES STRUCTUREES

(84) Benannte Vertragsstaaten:
**CH DE FR GB IT LI**

(30) Priorität: **15.10.1993 DE 4333620**

(43) Veröffentlichungstag der Anmeldung:
**04.10.1995 Patentblatt 1995/40**

(73) Patentinhaber: **LEICA LITHOGRAPHIE SYSTEME JENA GMBH**
**00745 Jena (DE)**

(72) Erfinder: **KLEY, Ernst-Bernhard**
**D-07749 Jena (DE)**

(74) Vertreter: **Geyer, Werner, Dr.-Ing. et al**
**Patentanwälte**
**Geyer, Fehners & Partner**
**Perhamerstrasse 31**
**80687 München (DE)**

(56) Entgegenhaltungen:
| | |
|---|---|
| EP-A- 0 338 110 | WO-A-94/25881 |
| DE-A- 1 497 404 | FR-A- 2 134 127 |
| US-A- 3 893 856 | US-A- 4 609 259 |
| US-A- 5 082 755 | US-A- 5 082 762 |

- **PATENT ABSTRACTS OF JAPAN vol. 7, no. 292 (E-219) (1437) 27. Dezember 1983 & JP,A,58 166 723 (HITACHI SEISAKUSHO K. K.)**

**Beschreibung**

Die Erfindung bezieht sich auf eine optische Fertigungsanordnung für Mikrolinsen und Mikrolinsenarrays mit einer Strahlungsquelle zur Erzeugung eines Strahlenbündels, das auf eine durch Belichten zu strukturierende Oberfläche eines Objekts auf einem Träger gerichtet ist, und mit Blenden, mittels deren Blendenöffnungen Teilstrahlenbündel aus dem Querschnitt des Strahlenbündels zur gleichzeitigen Erzeugung von Belichtungsbereichen auf der Oberfläche ausblendbar sind, wobei die Blenden relativ zum Träger und damit zur Oberfläche des Objekts in einer gemeinsamen Bewegungsrichtung bewegbar sind.

Die Erfindung dient insbesondere zur lithografischen Strukturierung von Oberflächen mit dem Ziel, Mikrolinsen und Mikrolinsenarrays herzustellen.

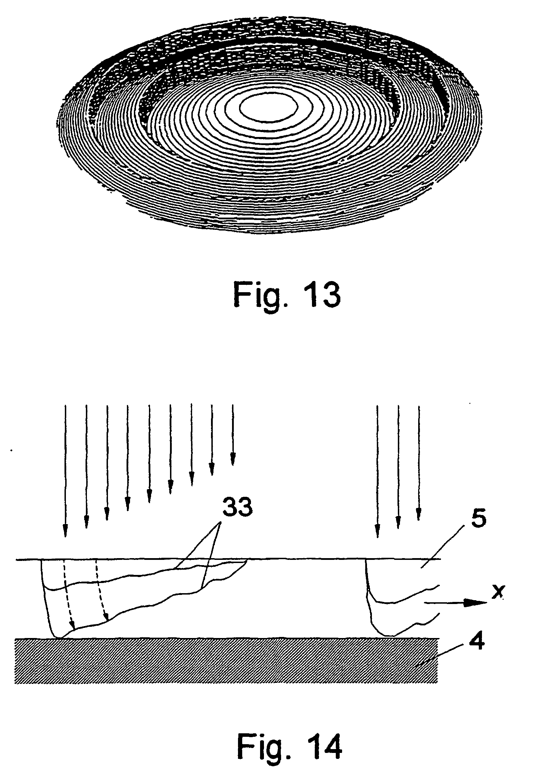

Solche Anordnungen bzw. Verfahren sind aus der US-A-3.893.856 bekannt. Bekannt sind weiter Vorrichtungen und Verfahren, die die Technik des Einschreibens variabler Dosiswerte zur Erzeugung von Oberflächenprofilen für die Elektronenstrahllithographie und für die Fotolithographie verwenden [*T. Fujita, H. Nishihara, J. Kayama*: Blazed grating and Fresnellenses fabricated by electronbeam lithography. Opt. Lett. 7 (1982) 12, p. 578; *M. Haruna, M. Takahishi, K Wakahayhashi, H. Nishihara*: Laser bean lithographed Micro-Fresnellenses. Appleid Optics/Vol. 29, No. 34/1 December 1990]. Es wird die Tatsache ausgenutzt, daß die Lösungsgeschwindigkeit eines strahlungsempfindlichen Resists im Entwicklerbad mittels der in den Resist eingebrachten Strahlungsdosis vorbestimmt werden kann. Dadurch ist es möglich, die laterale Strahlungsdosisverteilung so zu gestalten, daß man mit dem Abbruch der Entwicklung nach einer bestimmten Zeit das gewünschte Oberflächenprofil erhält. Figur 14 verdeutlicht diese Verfahrensweise schematisch.

Problematisch ist jedoch der hohe technische Aufwand zur Erzeugung der für dieses Verfahren notwendigen Dosisprofile, da die bisher eingesetzten Anlagen, wie Elektronenstrahlschreiber oder Laser-Patterngeneratoren körperlich groß und sehr kostspielig sind. Außerdem sind für ausgedehnte Oberflächenprofile sehr lange Bearbeitungszeiten notwendig. Speziell die Herstellung von Mikrolinsen und Mikrolinsenarrays verursacht einen hohen Zeitaufwand. Weiterhin sind die zum Schreiben der erforderlichen Dosisprofile notwendigen Datenmengen teilweise enorm, was eine entsprechend aufwendige Rechentechnik verlangt.

Aufgabe der Erfindung ist es, die Oberflächenbestrahlung so zu gestalten, daß die bei der Herstellung von Mikrolinsen und Mikrolinsenarrays notwendigen Bearbeitungszeiten und der erforderliche materielle Aufwand wesentlich verringert werden kann.

Die Aufgabe wird erfindungsgemäß durch eine Anordnung der eingangs genannten Art gelöst, bei der die Blenden in Form einer Vielfachblende in Bewegungsrichtung der Relativbewegung hintereinander angeordnet sind, wobei die Blendenöffnungen geometrische Flächen derart darstellen, daß jeder der durch die Teilstrahlenbündel gleichzeitig erzeugten Belichtungsbereiche auf der Oberfläche des Objekts, quer zur Bewegungsrichtung der Relativbewegung gesehen, eine in Bewegungsrichtung nicht konstante Ausdehnung aufweist. Die Aufgabe wird weiter durch ein Verfahren der eingangs genannten Art gelöst, bei dem die Blenden in einer Vielfachblende in Bewegungsrichtung der Relativbewegung hintereinander ausgebildet werden, und daß mittels der Teilstrahlenbündel auf der Oberfläche des Objekts gleichzeitig Belichtungsbereiche erzeugt werden, deren jeder quer zur Bewegungsrichtung der Relativbewegung gesehen eine in Bewegungsrichtung nicht konstante Ausdehnung aufweist.

Die Relativbewegung erfolgt in mindestens einer von zwei in einem Winkel zueinander geneigten Richtungen. Vorteilhafterweise sollte der Winkel 90° betragen, kann aber auch von 90° verschieden sein. Zur Herstellung von Linsenarrays werden in Richtung der Relativbewegung parallel nebeneinanderliegende Belichtungen erzeugt. Es ist auch möglich als Relativbewegung eine Drehbewegung zu benutzen.

Vorteilhafterweise ist als Einrichtung zur Formung des Querschnittes des Strahlenbündels eine Blende vorgesehen, deren Öffnung in Bewegungsrichtung gemeinsam mit der Geschwindigkeit der Relativbewegung die Dosis bestimmt.

Die Blende kann eine Vielfachblende sein, bei der in Bewegungsrichtung Einzelblenden hintereinander angeordnet sind, von denen die Blendenöffnung jeder Einzelblende in Bewegungsrichtung der Relativbewegung gemeinsam mit der Geschwindigkeit der Relativbewegung dosisbestimmend ist.

Zur Erzeugung der Relativbewegung, die im wesentlichen dem Abstand der Einzelblenden in Bewegungsrichtung entspricht, können Piezoaktuatoren mit der Vielfachblende verbunden sein.

Es ist von Vorteil, wenn die Blendenöffnungen einen, aus einer Geraden und einer Parabel gebildeten Rand aufweist, wobei die Parabel, deren Symmetrieachse in Bewegungsrichtung weist, zwei Punkte auf der sich senkrecht zur Bewegungsrichtung ausdehnenden Geraden miteinander verbindet.

Dosisprofile, die für die Herstellung konkaver fresnelscher Strukturen geeignet sind, können erzeugt werden, wenn in eine derartig umrandete Blendenöffnung mindestens ein abschattendes rechteckiges Element gelegt ist, dessen eine Seite mit der Geraden zusammenfällt und die gegenüberliegende Seite mit ihren Endpunkten die Parabel berührt.

Es ist von Vorteil, wenn von dem abschattenden Element freigelassene Bereiche mit ihren senkrecht zur Bewegungsrichtung gerichteten Rändern an einen gemeinsamen Rand gelegt sind.

Die Blendenöffnung kann auch einen aus zwei Parabeln gebildeten Rand aufweisen, wobei die Parabeln, die eine gemeinsame, in Richtung der Bewegung weisende Symmetrieachse besitzen, in und entgegengesetzt zur Bewegungsrichtung konvex ausgebildet sind und auf einer sich senkrecht zur Bewegungsrichtung ausdehnenden Geraden liegende gemeinsame Schnittpunkte aufweisen.

Zur Herstellung konvexer Strukturen dienen Blenden, deren Blendenöffnung ein in einer rechteckigen Umrandung von einem abschattenden Element freigelassener Abschnitt ist, wobei ein Seitenpaar der Umrandung sich senkrecht zur Bewegungsrichtung ausdehnende Seiten aufweist.

Konvexe Zylinderlinsen entstehen aus Dosisprofilen, die mit einer Blendenöffnung erzeugt sind, bei der eine der sich senkrecht zur Bewegungsrichtung ausdehnenden Seiten mit einem geraden Rand des abschattenden Elementes zusammenfällt, dessen übriger Rand eine Parabel mit einer Symmetrieachse in Bewegungsrichtung ist, die zwei Punkte auf dem geraden Rand miteinander verbindet.

Für konvexe Fresnellinsen sollte das abschattende Element aus Teilelementen bestehen, die durch Entfernen von mindestens einem rechteckigen Abschnitt aus einer Fläche übrigbleiben, die von einer Geraden und einer Parabel umschlossen ist, wobei die Parabel, deren Symmetrieachse in Bewegungsrichtung weist, zwei Punkte auf der sich senkrecht zur Bewegungsrichtung ausdehnenden Geraden miteinander verbindet. Eine Seite des rechteckigen Abschnitts fällt mit der Geraden zusammen, und die gegenüberliegende Seite berührt mit ihren Endpunkten die Parabel. Schließlich werden die Teilelemente mit ihren geraden, senkrecht zur Bewegungsrichtung gerichteten Rändern an eine der sich senkrecht zur Bewegungsrichtung ausdehnenden Seiten der rechteckigen Umrandung gelegt.

Es sind auch Blenden anwendbar, deren Öffnung einem rechtwinkligen Dreieck entspricht, wobei eine der rechtwinklig zueinander gerichteten Seiten in Bewegungsrichtung weist.

Als Öffnung kann auch eine gleichschenklige Dreieckform dienen, die mit ihrer durch die gleichschenkligen Seiten gebildeten Spitze in Bewegungsrichtung weist.

Vorteilhaft ist es, wenn zur Einstellung von Form oder Größe der Blende Einstellschieber vorgesehen sind.

Als Einrichtung zur Formung des Querschnitts des Strahlenbündels kann auch ein Bildschirm verwendet werden, der den geformten Bereich direkt projiziert. Die Form des mit dem Bildschirm erzeugten Bereiches entspricht den Formen, die mit den Blenden erzeugt werden.

Vorteilhafte Weiterbildungen der Erfindung sind in den Unteransprüchen 2 bis 14 aufgeführt.

Die Erfindung soll nachstehend anhand der schematischen Zeichnungen näher erläutert werden. Es zeigen:

Fig. 1    eine erfindungsgemäße Anordnung zur Herstellung strukturierter Oberflächen

Fig. 2    eine Prinzipdarstellung zum erfindungsgemäßen Verfahren

Fig. 3a    eine einseitig in Bewegungsrichtung konvexe parabolische Blende

Fig. 3b    eine zweiseitig in Bewegungsrichtung konvexe parabolische Blende

Fig. 3c    eine Vielfachblende, die aus Einzelblenden gemäß Fig. 3 a zusammengesetzt ist

Fig. 4a-c    parabolische Blenden und damit erzeugte Strukturen

Fig. 5a-c    parabolische Blenden und damit erzeugte Strukturen

Fig. 6a-c    Blendenform und damit erzeugte fresnelscher Strukturen

Fig. 6d    die Erzeugung der Blendenform nach Fig. 6a

Fig. 7a-d    Blendenform und damit erzeugte fresnelscher Strukturen

Fig. 7d    die Erzeugung der Blendenform nach Fig. 7a

Fig. 8a-c    eine keilförmige Blende und damit erzeugte Strukturen

Fig. 9a-c    eine dreieckförmige Blende und damit erzeugte Strukturen

Fig. 10a, b    Blenden mit variabler Geometrie

Fig. 11    schematische Anordnung zur parallelen Herstellung von strukturierten Oberflächen

Fig. 12    schematische Anordnung zur Herstellung von runden Fresnellinsen

Fig. 13    einen Ausschnitt aus einer runden Fresnellinse

Fig. 14    die prinzipielle Verfahrensweise bei der Herstellung von Oberflächenprofilen mit variablen Dosiswerten

Fig 15a, b    einfache mäanderformige Bewegung und damit erzeugbare Strukturen

Fig. 16a, b    gekreuzte mäanderförmige Bewegung und damit erzeugbare Strukturen

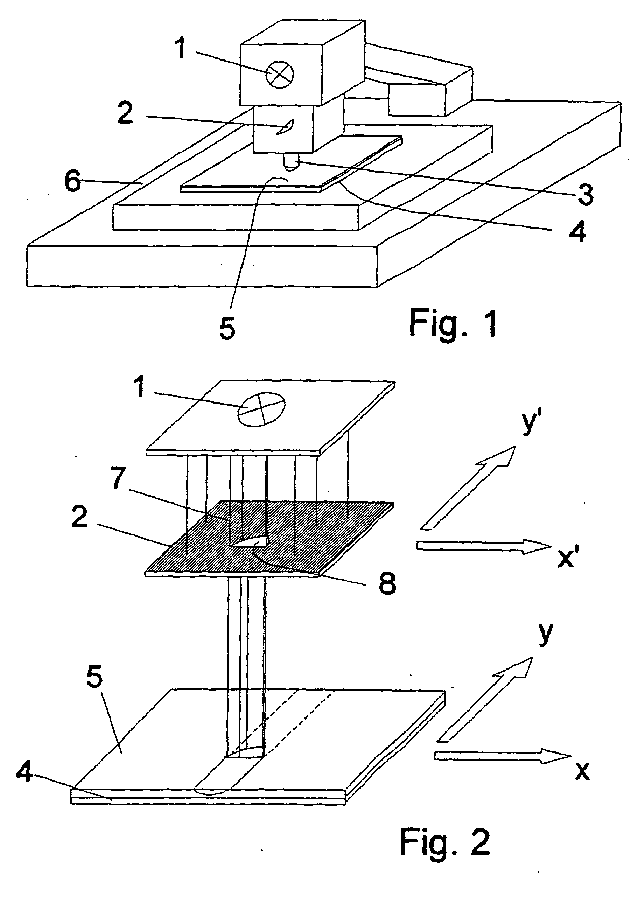

Die Anordnung gemäß Fig. 1 enthält in Strahlungsrichtung nacheinander angeordnet als Strahlungsquelle eine Lichtquelle 1 mit einem Kondensor, als Einrichtung zur Strahlformung eine Blende 2, ein Objektiv 3 als abbildendes optisches System und ein Objekt, das auf einem Träger 4 eine zu strukturierende Oberfläche in Form einer Resistschicht 5 enthält. Das Objekt ist auf einem X-Y-Positioniertisch 6 fixiert.

Die Blenden 2 kann sowohl fest installiert als auch auswechselbar sein.

Als Strahlungsquelle können auch eine Elektronen-, eine Röntgen- oder eine Ionenquelle dienen.

Nach Fig. 2 wird ein von der Lichtquelle 1 ausgehendes Lichtbündel 7 in seinem Querschnitt von der Blende 2 so geformt, daß aus dem Gesamtquerschnitt ein vom übrigen Teil abgetrennter Bereich 8 entsteht. Durch verschiedene, dem Fachmann geläufige technische Maßnahmen, ist der geformte Bereich 8 relativ zu der zu strukturierenden Oberfläche bewegbar. So ist sowohl eine Bewegung des Objektes durch den Positioniertisch 6 als auch des Lichtbündels 7 gemeinsam mit der Einrichtung zur Strahlformung aber auch die beiderseitige Bewegung möglich. Eine andere Möglichkeit zur Erzeugung der relativen Bewegung des Bereiches 8 besteht darin, nur die Blende 2 linear zu verschieben oder eine rotatorische Relativbewegung um eine vertikale, zur Achse des Lichtbündels 7 parallel gerichtete Achse Z-Z zu erzeugen.

Allen Ausführungen gemeinsam ist die Blendengestaltung in Abhängigkeit von der Bewegungsrichtung der Relativbewegung, da die Öffnung in Bewegungsrichtung gemeinsam mit der Geschwindigkeit der Relativbewegung die auf das Objekt auftreffende Dosis bestimmt.

In den meisten Fällen wird die Intensitätsverteilung über den Bereich 8 homogen sein. Es ist aber zur Erzielung bestimmter Arbeitsergebnisse auch möglich, die Intensitätsverteilung über den Bereich 8 definiert inhomogen zu gestalten.

Mit dem abbildenden optischen System kann sowohl eine scharfe Abbildung des geformten Bereiches als auch eine unscharfe Abbildung erzeugt werden.

Letztere führt zu gleichmäßigeren Profilen, wenn die Unschärfe durch Verwendung z. B. einer Zylinderlinse in Richtung der relativen Bewegung gelegt wird, d. h. es verringern sich die Anforderungen an die Genauigkeit der relativen Bewegung.

Durch die unscharfe Abbildung kann auch die Größe der relativen Bewegung verringert werden.

Insbesondere bei Röntgenstrahlen ist auch eine direkte Abbildung des Bereiches 8 durch Schattenprojektion möglich.

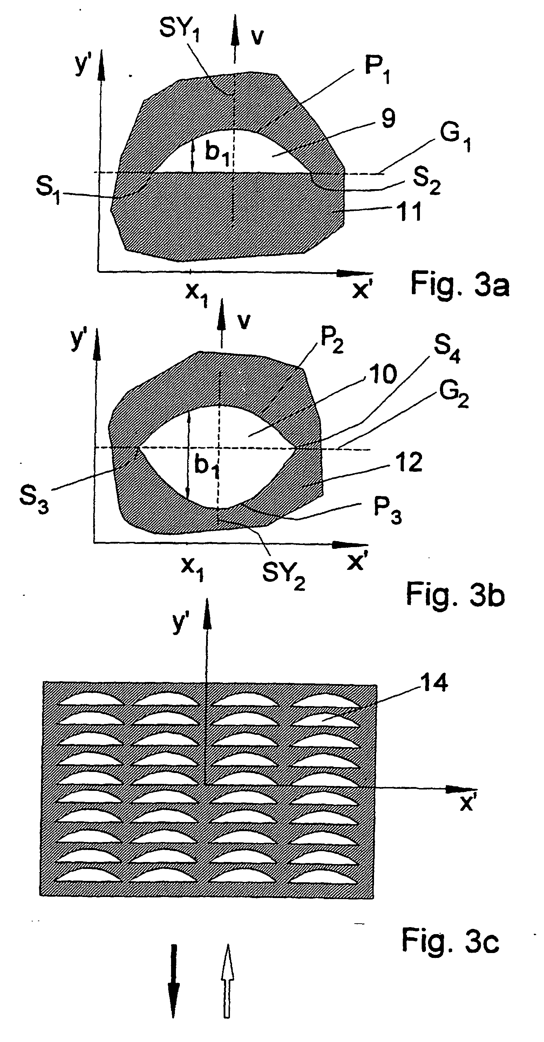

Die den in den Figuren 3a und 3b angegebenen Blendenformen besitzen lichtdurchlassende, zumindest teilweise parabolische Blendenöffnungen 9, 10 und abschattende Bereichen 11, 12.

Die Blendenöffnung 9 wird von einem aus einer Geraden $G_1$ und einer Parabel $P_1$ gebildeten Rand umschlossen, wobei die Parabel $P_1$, deren Symmetrieachse $SY_1$ in Bewegungsrichtung der Relativbewegung (hier in Y') weist, zwei Punkte $S_1$ und $S_2$ auf der sich senkrecht zur Bewegungsrichtung ausdehnenden Geraden $G_1$ miteinander verbindet.

Die mit dieser Blende erzielbare Dosis ist proportional der Bestrahlungszeit t, die wiederum abhangig ist von der Geschwindigkeit v der Relativbewegung, mit der der durch die Blendenöffnung hindurchgelassene Bereich des Lichtstrahlenbündels 7 über die zu strukturierende Oberfläche bewegt wird:

$$t(X') = b(X')/v.$$

Die Größe b ist die Öffnung der Blende in Bewegungsrichtung, die im vorliegenden Beispiel die Form der Parabel $P_1$ annimmt. Je nach Anwendungsfall ist eine Blende mit entsprechender Öffnung wählbar.

Die Öffnung b, die für einen Ort $x_1$ mit $b_1$ bezeichnet ist, ist die zweite Größe neben der Geschwindigkeit v, mit der die auf die zu strukturierende Oberfläche einwirkende Dosis bei der Relativbewegung über den gesamten Weg der Bewegung bestimmt ist. Von einem maximalen Dosiswert in der Mitte der Blende verringert sich die Dosis bis zu den Schnittpunkten $S_1$ und $S_2$ der Parabel $P_1$ mit der Geraden $G_1$ auf einen Wert Null.

Das mit dieser Blende erzielbare Dosisprofil verläuft senkrecht zur Bewegungsrichtung über den gesamten Weg der Bewegung.

Zeitliche und räumliche Homogenität des Lichtstrahlenbundels 7 und eine konstante Geschwindigkeit v gewährleisten eine gleichmäßige und definierte Strukturtiefe.

Die in Fig. 3b dargestellte Blende besitzt einen Rand aus zwei Parabeln $P_2$ und $P_3$, die eine gemeinsame, in Richtung der Bewegung weisende Symmetrieachse $SY_2$ besitzen. Die Parabeln $P_2$ und $P_3$ sind in und entgegengesetzt zur Bewegungsrichtung konvex ausgebildet und weisen auf einer sich senkrecht zur Bewegungsrichtung ausdehnenden Geraden $G_2$ liegende gemeinsame Schnittpunkte $S_3$ und $S_4$ auf. Die Gerade $G_2$ hat in diesem Beispiel keine randbildende Funktion.

Die beiden Parabeln $P_2$ und $P_3$ können, wie bei der vorliegenden Ausführung, unsymmetrisch zueinander aber auch spiegelsymmetrisch sein.

Die mit der Blende nach Fig. 3b erzeugbaren Dosisprofile sind gleichartig zu denen, die bei der Anwendung der Blende nach Fig. 3a entstehen. Der Vorteil der zweiseitigen Parabelform besteht darin, Ungenauigkeiten, insbesondere Verkippungen zu kompensieren.

Die in Fig. 3c dargestellte Vielfachblende enthält in Bewegungsrichtung hintereinander angeordnete Einzelblenden mit Blendenöffnungen 14, die in ihrer Form der Blendenöffnung 9 entsprechen. Zur Erzeugung von Dosisprofilen ist es mit einer derartigen Vielfachblende ausreichend, die Relativbewegung mit einer Weglänge auszuführen, die durch die Abstande der Blendenöffnung 14 untereinander bestimmt ist.

Im Ergebnis entsteht ein Dosisprofil, das parallel nebeneinander angeordneten Zylinderlinsen entspricht. Werden zwei Belichtungsvorgänge in zueinander senkrechten Richtungen ausgeführt, entspricht das Dosisprofil einem Linsenarray. Variationsmöglichkeiten beim Aufbau der Vielfachblende sind in der Anordnung, der Form und der Größe der Einzelblenden gegeben.

Eine Vielfachblende kann beispielsweise so gestaltet sein, daß bei einer Abmessung von 50 x 50 mm 10 000 Einzelblenden in Form der Blendenöffnungen 14 mit Abmessungen von 500 µm senkrecht zur Bewegungsrichtung und von maximal 250 µm in Bewegungsrichtung.

Die Belichtung kann durch Schattenprojektion mit kollidiertem Licht erfolgen. Vorteilhaft ist auch die Verwendung von Röntgenstrahlen.

Die Lösung stellt eine kostengünstige Variante zur Herstellung von Riesenarrays dar.

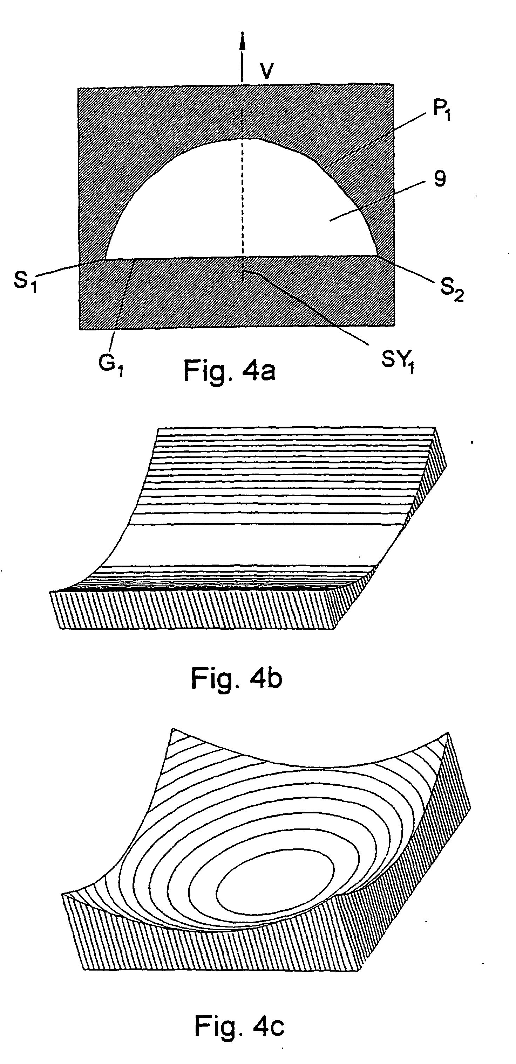

Die Figuren 4 bis 9 verdeutlichen, mit welchen Blendenformen welche Ergebnisse erzielt werden können. Natürlich ist die Erfindung nicht auf die hier beispielhaft genannten Formen beschränkt.

Während die mit a bezeichneten Figuren die Blendenform angeben, zeigen die Figuren b das Ergebnis deren Anwendung in einer Bewegungsrichtung und die Figuren c das Anwendungsergebnis im Kreuzungsbereich senkrecht zueinander gerichteter Bewegungsrichtungen.

Die Blende nach Fig. 4 a entspricht der bereits in Fig. 3a beschriebenen.

Wird als zu strukturierende Oberfläche ein Positivresist für die Resistschicht 5 verwendet, so entsteht bei einer Relativbewegung eines mit einer parabolischen Blende gemäß Fig. 4a geformten Bereiches zur Oberfläche und in Richtung der Parabel nach einem entsprechenden Entwicklungsprozeß eine konkave Zylinderlinse gemäß Fig. 4b.

Werden zwei Belichtungsvorgänge in zueinander senkrechten Richtungen vorgenommen, ist eine radiale konkave Linse herstellbar, da im Überlagerungsbereich beider Belichtungsvorgänge eine Dosisverteilung entsteht, die einer derartigen Linse entspricht (Fig. 4c).

Durch eine entsprechende Wahl unterschiedlicher Blendengrößen sind auch elliptische Linsen herstellbar.

Die zwei Belichtungsvorgänge können auch mit Relativbewegungen erfolgen, deren Bewegungsrichtungen um einen von 90° verschiedenen Winkel zueinander geneigt sind. Im Ergebnis entstehen "verschobene" Abarten von Linsen.

Mit der Geschwindigkeit der Relativbewegung sind die Brennweiten der jeweiligen Linse oder der Komponenten der elliptischen Linse festgelegt.

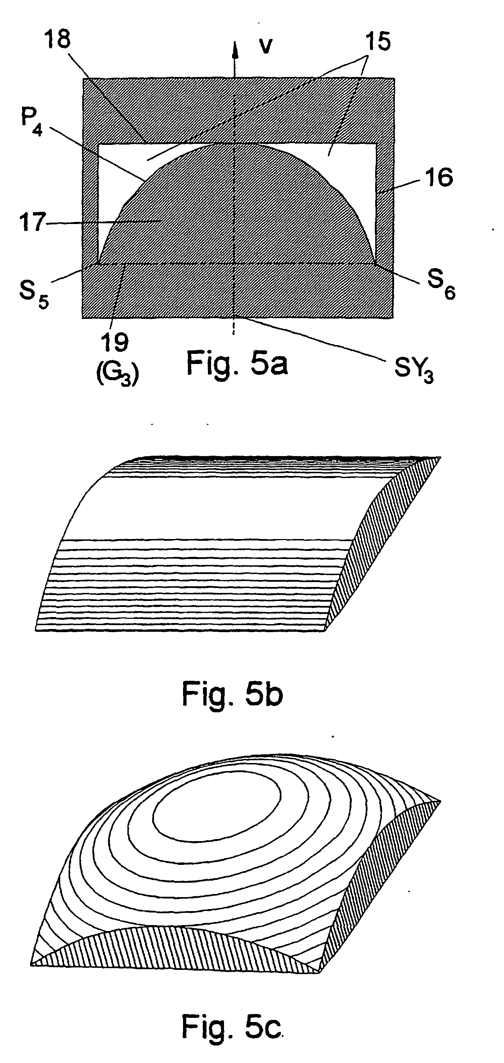

Mit einer Blende nach Fig. 5a sind konvexe Zylinderlinsen nach Fig. 5b und radiale konvexe Linsen nach Fig. 5c realisierbar.

Die Blende nach Fig. 5a besitzt eine Blendenöffnung 15, die einem in einer rechteckigen Umrandung 16 von einem abschattenden Element 17 freigelassenen Abschnitt entspricht. Von einem Seitenpaar der Umrandung sind Seiten 18, 19 senkrecht zur Bewegungsrichtung gerichtet. Die Seite 19 fällt mit einem geraden Rand $G_3$ des abschattenden Elementes 17 zusammen, dessen übriger Rand eine Parabel $P_4$ mit einer Symmetrieachse $SY_3$ in Bewegungsrichtung ist, die zwei Punkte $S_5$ und $S_6$ auf dem geraden Rand $G_3$ miteinander verbindet.

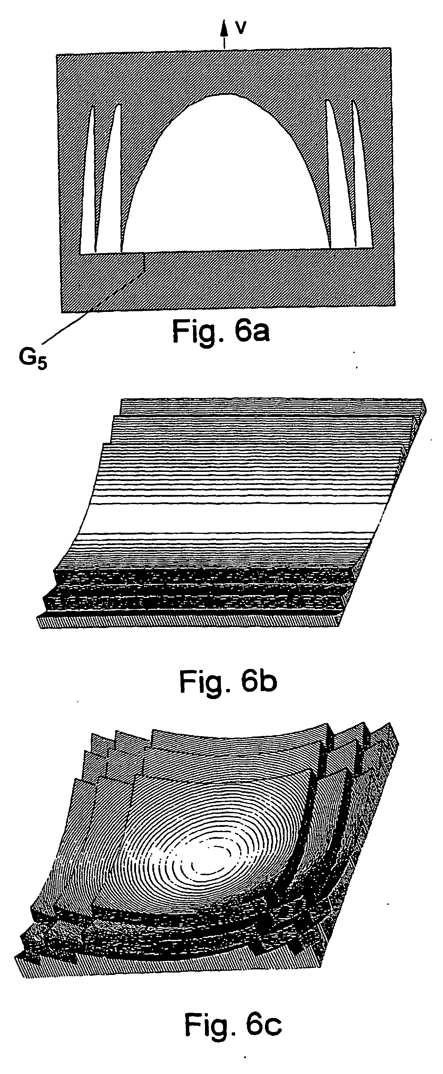

Eine Blende gemäß Fig. 6a mit einer Blendenöffnung 20 dient zur Herstellung von Linsen fresnelscher Art. Bei einmaliger Anwendung in einer Bewegungsrichtung entsteht eine konkave Fresnelzylinderlinse und bei zwei Belichtungsvorgängen in zueinander senkrechten Richtungen eine konkave Fresnellinse, deren Form bereits in der deutschen Patenanmeldung P 43 14 574.4 beschrieben ist.

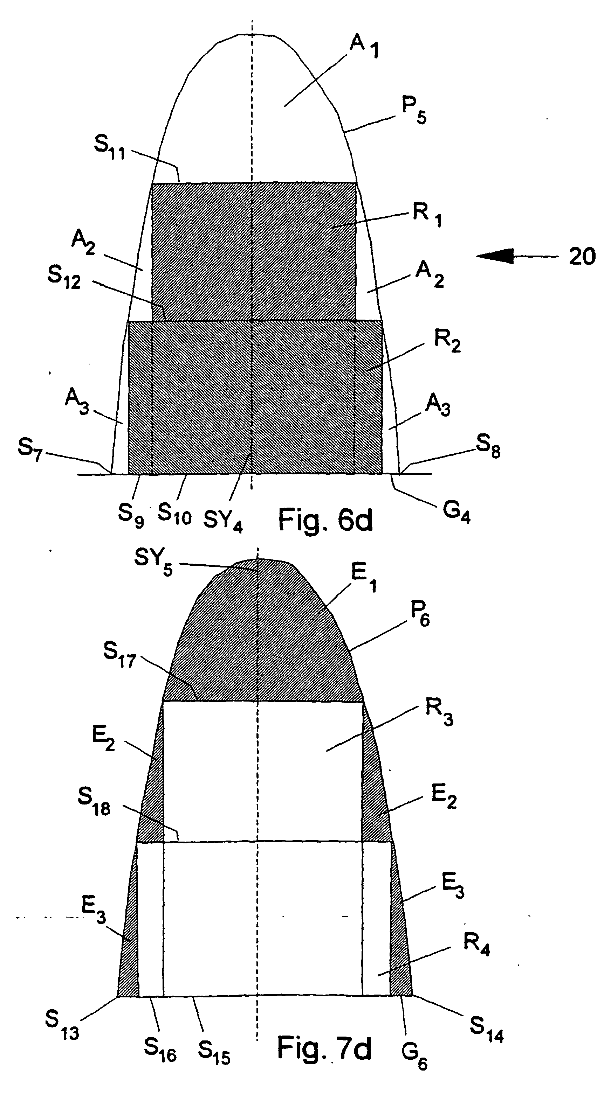

Eine solche Blende nach Fig. 6a ist entsprechend Fig. 6d derartig erzeugt, daß in eine Blendenöffnung 20', deren Umrandung sich aus einer Geraden $G_4$ und einer Parabel $P_5$ mit Schnittpunkten $S_7$, $S_8$ zusammensetzt, abschattende rechteckförmige Elemente $R_1$, $R_2$ eingelegt sind, die eine gemeinsame Seite $S_9$, $S_{10}$ mit der Geraden $G_4$ haben. Die den Seiten $S_9$, $S_{10}$ gegenüberliegende Seite $S_{11}$, $S_{12}$ liegen mit ihren Endpunkten an der Parabel $P_5$ an, die eine in Bewegungsrichtung weisende Symmetrieachse $SY_4$ besitzt. Die freigelassenen Abschnitte $A_1$, $A_2$, $A_3$, bilden die Blendenöffnung 20, indem sie an einen gemeinsamen Rand $G_5$ gelegt sind.

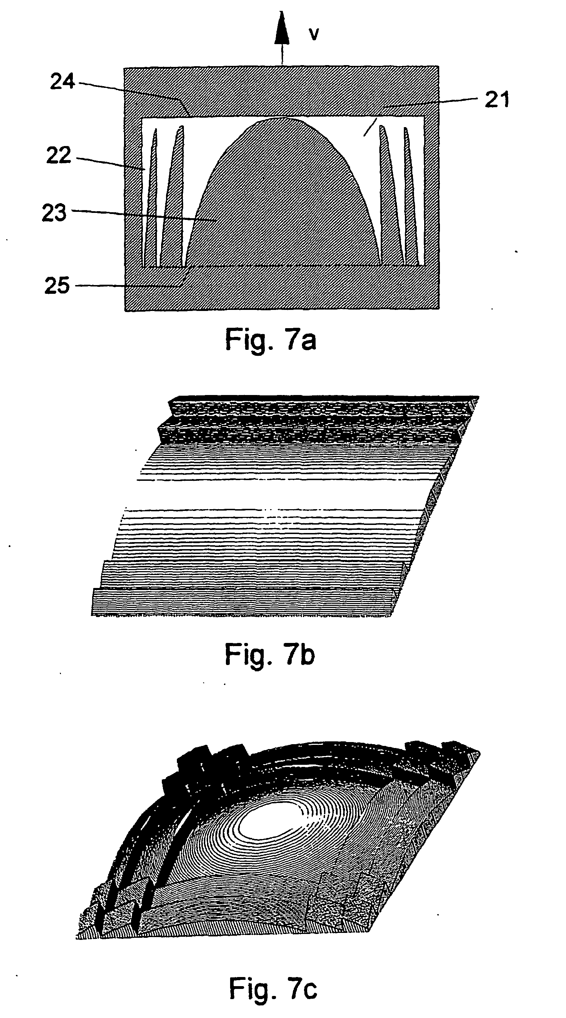

Eine Blende Fig. 7a liefert konvexe Fresnel-Zylinderlinsen bzw. konvexe Fresnellinsen. Derartige Linsen sind ebenfalls in der deutschen Patenanmeldung P 43 14 574.4 bereits beschrieben.

Die Blende nach Fig. 7a besitzt eine Blendenöffnung 21, die ein in einer rechteckigen Umrandung 22 von einem abschattenden Element 23 freigelassener Abschnitt ist, wobei ein Seitenpaar der Umrandung 22 sich senkrecht zur Bewegungsrichtung ausdehnende Seiten 24, 25 aufweist.

Das abschattende Element 23 besteht nach Fig. 7d aus Teilelementen $E_1$, $E_2$, $E_3$, die durch Entfernen von mindestens einem rechteckigen Abschnitt $R_3$, $R_4$ aus einer Fläche übrigbleiben, die von einer Geraden $G_6$ und einer Parabel $P_6$ umschlossen ist, wobei die Parabel $P_6$, deren Symmetrieachse $SY_5$ in Bewegungsrichtung weist, zwei Punkte $S_{13}$, $S_{14}$ auf der sich senkrecht zur Bewegungsrichtung ausdehnenden Geraden $G_6$ miteinander verbindet. Während eine Seite $S_{15}$, $S_{16}$ der rechteckigen Abschnitte $R_3$, $R_4$ mit der Geraden $G_6$ zusammenfällt, berühren die gegenüberliegende Seiten $S_{17}$, $S_{18}$ mit ihren Endpunkten die Parabel $P_6$.

Die Teilelemente bilden in Fig. 7a die Blendenöffnung 21, indem sie an die Seite 25 gelegt sind. Es ist auch möglich die andere Seite 24 zur Anlage zu benutzen.

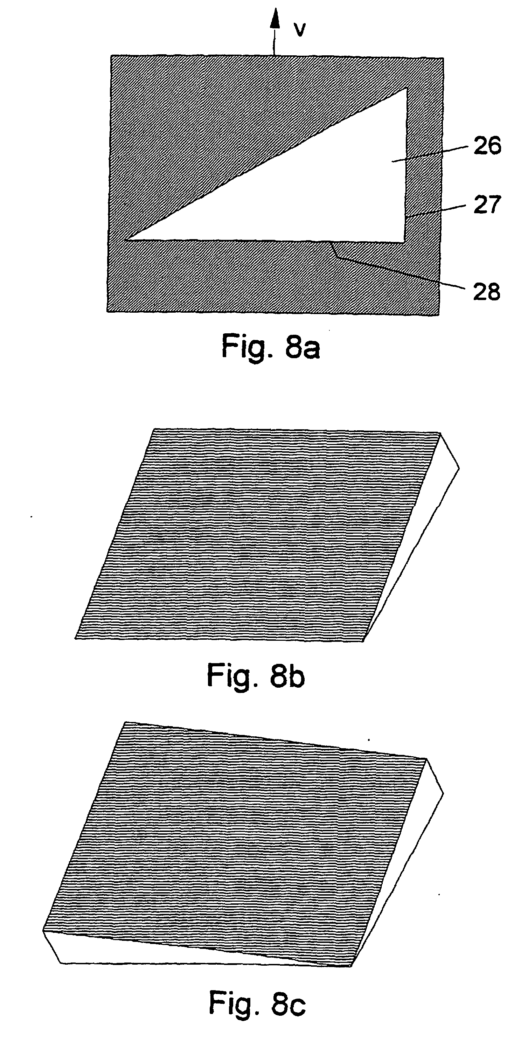

Eine weitere geeignete Blende (Fig. 8a) kann als Blendenöffnung ein rechtwinkliges Dreiecks 26 besitzen, von dem eine der rechtwinklig zueinander gerichteten Seiten 27, 28 in Bewegungsrichtung weist.

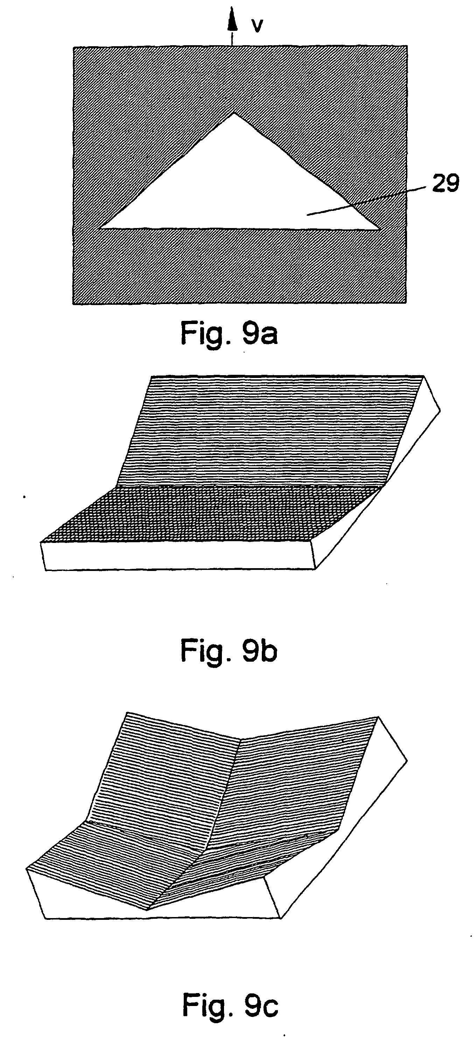

Nach Fig. 9a liegt eine gleichschenklige dreieckige Blendenöffnung 29 vor, die mit ihrer durch die gleichen Seiten gebildeten Spitze in Bewegungsrichtung weist.

Die Blendenöffnung 26 führt zu entsprechenden Keilprofilen, die Öffnung 29 zu Dreieck- und Pyramidenprofilen.

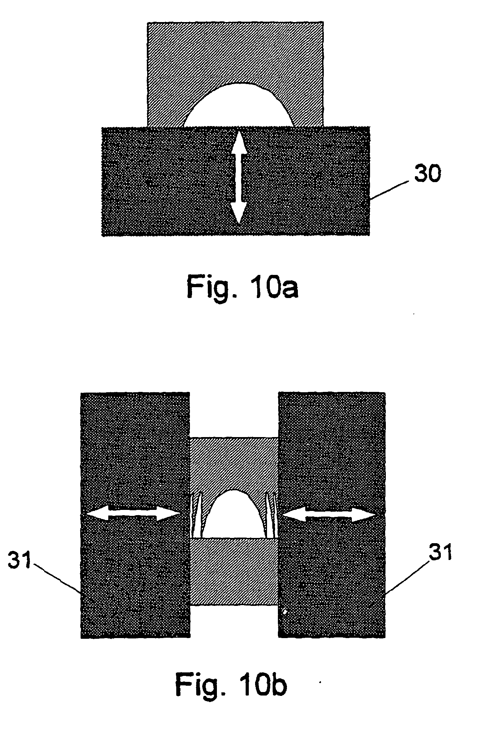

Die in den Figuren 10a und 10b dargestellten Blenden sind mit Einstellschiebern 30 und 31 versehen, mit denen eine Blendeneinstellung vorgenommen werden kann.

Während mit dem Einstellschieber 30 die Basisbreite veränderbar ist, kann mit dem Einstellschieber 31 eine Veränderung der Strukturbreite erfolgen.

Damit sind Linsen unterschiedlich großer Geometrie einfach herstellbar. Die Verstellung ist automatisierbar und kann auch während eines Belichtungsvorganges erfolgen, um Strukturbreiten zu variieren.

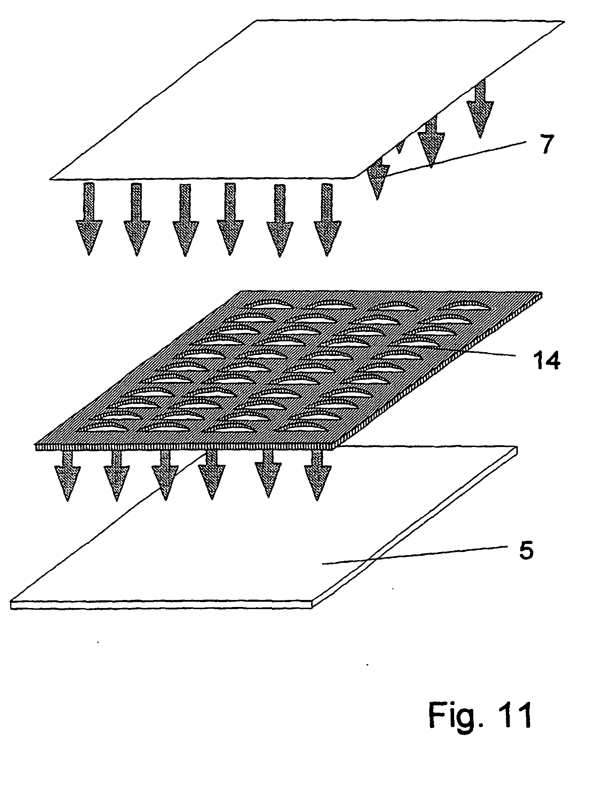

Fig. 11 verdeutlicht den Einsatz einer Vielfachblende als Einrichtung zur Strahlformung. In ihrer Funktion entspricht die Lösung derjenigen aus Fig. 2.

Zur relativen Bewegung der Vielfachblende sind nicht dargestellte Piezoaktuatoren geeignet, die an der Blende angekoppelt sind und die gut steuerbare Bewegungen, z. B. in Form von Oszillatioen erzeugen.

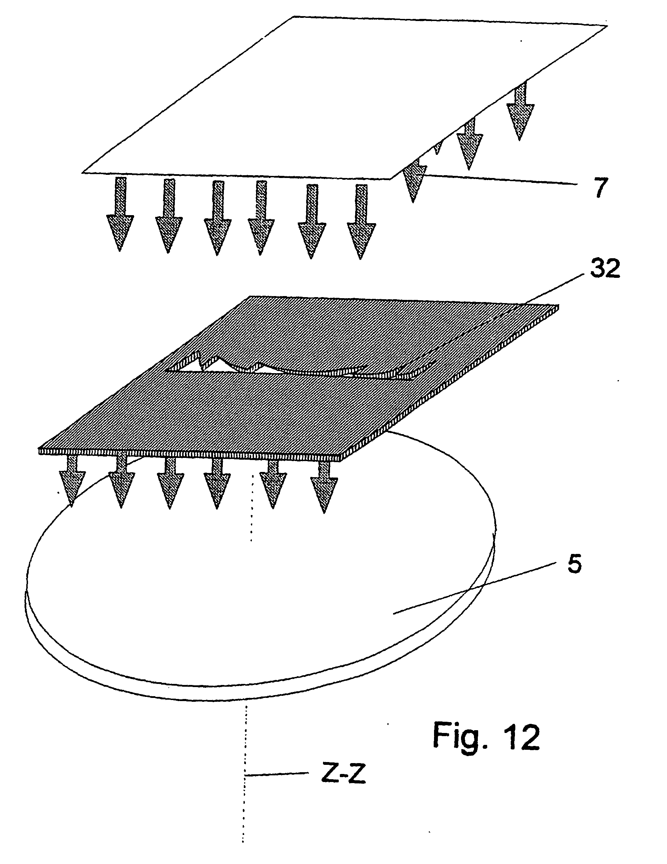

Mit der in Fig. 12 schematisch dargestellten Anordnung können Dosisprofile, die runden Fresnellinsen entsprechen, erzeugt werden. Die eingesetzte Blende hat einen entsprechenden Blendenöffnung 32.

In ihrer Funktion entspricht die Lösung derjenigen aus Fig. 2 mit dem Unterschied, daß die Relativbewegung durch eine Drehbewegung um die Achse Z-Z erzeugt wird.

Eine entsprechende hergestellte runde Fresnellinse zeigt Fig. 13.

Fig. 14 beinhaltet die prinzipielle Verfahrensweise bei der Herstellung von Oberflächenprofilen mit variablen Dosiswerten, stellt also eine Anwendung für die mit der Erfindung realisierbaren Dosiswerte dar. Durch eine in X-Richtung unterschiedliche Bestrahlungsintensität bildet sich beim Entwickeln der Resistschicht 5 eine Entwicklungsfront 33 heraus, die mit der Zeitdauer der Entwicklung voranschreitet und ein Oberflächenprofil im Resist erzeugt.

Andere Anwendungen sind bei strahlungsempfindlichen Objekten gegeben, in die das Oberflächenprofil hineinentwickelt wird.

Eine direkte Profilierung des Objektes kann auch durch Profilätzen erfolgen, indem die Strahlung die Struktur unmittelbar in das Material einarbeitet, wie z. B. beim Ionenstrahlätzen.

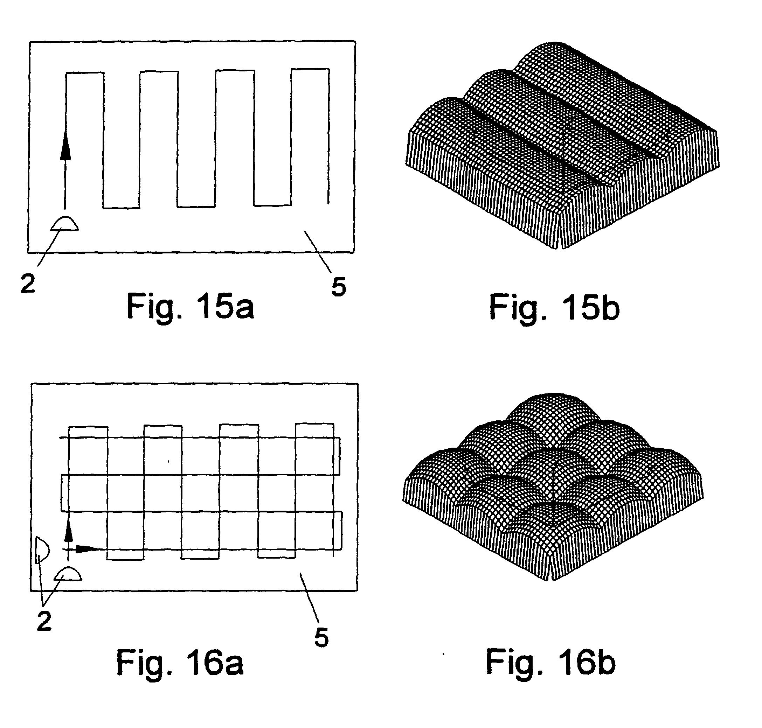

Mit den in den Figuren 15 und 16 dargestellten Verfahrensweisen der mäanderförmigen Belichtung in Pfeilrichtung können Zylinderlinsen- und Linsenarrays (Fig. 15 b bzw. Fig. 16 b) hergestellt werden.

**Patentansprüche**

1. Optische Fertigungsanordnung für Mikrolinsen und Mikrolinsenarrays mit einer Strahlungsquelle (1) zur Erzeugung eines Strahlenbündels (7), das auf eine durch Belichten zu strukturierende Oberfläche eines Objekts auf einem Träger (4) gerichtet ist, und mit Blenden, mittels deren Blendenöffnungen (9, 10, 14, 15, 20, 21, 26, 29, 32) Teilstrahlenbündel (8) aus dem Querschnitt des Strahlenbündels (7) zur gleichzeitigen Erzeugung von Belichtungsbereichen auf der Oberfläche ausblendbar sind, wobei die Blenden retativ zum Träger (4) und damit zur Oberfläche des Objekts in einer gemeinsamen Bewegungsrichtung bewegbar sind, **dadurch gekennzeichnet, daß** die Blenden in Form einer Vielfachblende in Bewegungsrichtung der Relativbewegung hintereinander angeordnet sind, wobei die Blendenöffnungen (9, 10, 14, 15, 21, 26, 29, 32) geometrische Flächen derart darstellen, daß jeder der durch die Teilstrahlenbündel (8) gleichzeitig erzeugten Belichtungsbereiche auf der Oberfläche des Objekts, quer zur Bewegungsrichtung der Relativbewegung gesehen, eine in Bewegungsrichtung nicht konstante Ausdehnung aufweist.

2. Optische Fertigungsanordnung nach Anspruch 1, **dadurch gekennzeichnet, daß** Piezoaktuatoren mit der Vielfachblende verbunden sind, um die Blenden relativ zum Träger und damit zur Oberfläche des Objekts zu bewegen.

3. Optische Fertigungsanordnung nach Anspruch 2, **dadurch gekennzeichnet, daß** die Blenden relativ zum Träger (4) und damit zur Oberfläche des Objekts über eine Weglänge bewegbar sind, die dem Abstand der Blendenöffnungen in Bewegungsrichtung entspricht.

4. Optische Fertigungsanordnung nach einem der Ansprüche 1 bis 3, **dadurch gekennzeichnet, daß** jede der Blendenöffnungen (9, 20) einen aus einer Geraden ($G_1$, $G_4$) und einer Parabel ($P_1$, $P_5$) gebildeten Rand aufweist, wobei die Parabel ($P_1$, $P_5$), deren Symmetrieachse ($SY_1$, $SY_4$) in Bewegungsrichtung weist, zwei Punkte ($S_1$, $S_2$, $S_7$, $S_8$) auf der sich senkrecht zur Bewegungsrichtung ausdehnenden Geraden ($G_1$, $G_4$) miteinander verbindet.

5. Optische Fertigungsanordnung nach einem der Ansprüche 1 bis 3, **dadurch gekennzeichnet, daß** jede der Blendenöffnungen (10) einen aus zwei Parabeln ($P_2$, $P_3$) gebildeten Rand aufweist, wobei die Parabeln ($P_2$, $P_3$), die eine gemeinsame, in Richtung der Bewegung weisende Symmetrieachse ($SY_2$) besitzen, in und entgegengesetzt zur Bewegungsrichtung konvex ausgebildet sind und auf einer sich senkrecht zur Bewegungsrichtung ausdeh-

nenden Geraden ($G_2$) liegende gemeinsame Schnittpunkte ($S_3$, $S_4$) aufweisen.

6. Optische Fertigungsanordnung nach Anspruch 4, **dadurch gekennzeichnet, daß** jeder der Blendenöffnungen (20) mindestens ein abschattendes rechteckiges Element ($R_1$, $R_2$) zugeordnet ist, dessen eine Seite ($S_9$, $S_{10}$) mit der Geraden ($G_4$) zusammenfällt und dessen gegenüberliegende Seite ($S_{11}$, $S_{12}$) mit ihren Endpunkten die Parabel ($P_5$) berührt.

7. Optische Fertigungsanordnung nach Anspruch 6, **dadurch gekennzeichnet, daß** von dem mindestens einen abschattenden rechteckigen Element ($R_1$, $R_2$) freigelassene Bereiche ($A_1$, $A_2$, $A_3$) mit ihren senkrecht zur Bewegungsrichtung gerichteten Rändern an einen gemeinsamen Rand ($G_5$) gelegt sind.

8. Optische Fertigungsanordnung nach einem der Ansprüche 1 bis 3, **dadurch gekennzeichnet, daß** jede der Blendenöffnungen (15, 21) ein in einer rechteckigen Umrandung (16, 22) von einem abschattenden Element (17, 23) freigelassener Abschnitt ist, wobei ein Seitenpaar der Umrandung sich senkrecht zur Bewegungsrichtung ausdehnende Seiten (18, 19, 25, 25) aufweist.

9. Optische Fertigungsanordnung nach Anspruch 8, **dadurch gekennzeichnet, daß** eine der sich senkrecht zur Bewegungsrichtung ausdehnenden Seiten (18, 19) mit einem geraden Rand ($G_3$) des abschattenden Elementes (17) zusammenfällt, dessen übriger Rand eine Parabel ($P_4$) mit einer Symmetrieachse ($SY_3$) in Bewegungsrichtung ist, die zwei Punkte ($S_5$, $S_6$) auf dem geraden Rand ($G_3$) miteinander verbindet.

10. Optische Fertigungsanordnung nach Anspruch 9, **dadurch gekennzeichnet, daß** das abschattende Element (23) aus Teilelementen ($E_1$, $E_2$, $E_3$) besteht, die durch Entfernen von mindestens einem rechteckigen Abschnitt ($R_3$, $R_4$) aus einer Fläche übrigbleiben, die von einer Geraden ($G_6$) und einer Parabel ($P_6$) umschlossen ist, wobei die Parabel ($P_6$), deren Symmetrieachse ($SY_5$) in Bewegungsrichtung weist, zwei Punkte ($S_{13}$, $S_{14}$) auf der sich senkrecht zur Bewegungsrichtung ausdehnenden Geraden ($G_6$) miteinander verbindet, eine Seite ($S_{15}$, $S_{16}$) des rechteckigen Abschnitts ($R_3$, $R_4$) mit der Geraden ($G_6$) zusammenfällt und die gegenüberliegende Seite ($S_{17}$, $S_{18}$) mit ihren Endprodukten die Parabel ($P_6$) berührt, und daß die Teilelemente ($E_1$, $E_2$, $E_3$) mit ihren geraden, senkrecht zur Bewegungsrichtung gerichteten Rändern an eine der sich senkrecht zur Bewegungsrichtung ausdehnenden Seiten (24, 25) der rechteckigen Umrandung (22) gelegt sind.

11. Optische Fertigungsanordnung nach einem der Ansprüche 1 bis 3, **dadurch gekennzeichnet, daß** jede der Blendenöffnungen einen aus einem rechtwinkligen Dreieck (26) gebildeten Rand aufweist und eine der rechtwinklig zueinander gerichteten Seiten (27, 28) in Bewegungsrichtung weist.

12. Optische Fertigungsanordnung nach einem der Ansprüche 1 bis 3, **dadurch gekennzeichnet, daß** jede der Blendenöffnungen einen aus einer gleichschenkligen Dreiecksform (29) gebildeten Rand aufweist, der mit seiner durch die gleichschenkligen Seiten gebildeten Spitze in Bewegungsrichtung weist.

13. Optische Fertigungsanordnung nach einem der Ansprüche 1 bis 12, **dadurch gekennzeichnet, daß** zur Einstellung von Form oder Größe der Blende Einstellschieber (30, 31) vorgesehen sind.

14. Optische Fertigungsanordnung nach Anspruch 1, **dadurch gekennzeichnet, daß** die Einrichtung zur Formung des Querschnittes des Strahlenbündels ein Bildschirm ist.

15. Optisches Fertigungsverfahren für Mikrolinsen und Mikrolinsenarrays durch Strukturierung einer Oberfläche eines Objekts auf einem Träger (4) mittels eines auf die Oberfläche gerichteten Strahlenbündels (7) einer Strahlungsquelle (1), wobei aus dem Querschnitt des Strahlenbündels (7) mittels Blenden mit Blendenöffnungen (9, 10, 14, 15, 20, 21, 26, 29, 31) Teilstrahlenbündel (8) ausgeblendet werden, die gleichzeitig Belichtungsbereiche auf der Oberfläche des Objekts erzeugen, wobei diese Belichtungsbereiche relativ zum Träger und damit zur Oberfläche des Objekts in einer gemeinsamen Bewegungsrichtung bewegt werden, **dadurch gekennzeichnet, daß** die Blenden in einer Vielfachblende in Bewegungsrichtung der Relativbewegung hintereinander ausgebildet werden, und daß mittel der Teilstrahlenbündel auf der Oberfläche des Objekts gleichzeitig Belichtungsbereiche erzeugt werden, deren jeder quer zur Bewegungsrichtung der Relativbewegung gesehen eine in Bewegungsrichtung nicht konstante Ausdehnung aufweist.

**Claims**

1. An optical arrangement for the manufacture of microlenses and microlens arrays, said arrangement comprising a radiation source (1) for generating a beam (7), which is directed on a surface of an object on a carrier (4), which surface is to be structured by exposure, and comprising stops by means of whose stop openings (9, 10, 14, 15, 20, 21, 26, 29, 32) partial beams (8) may be cut out from the cross-section of the beam (7) to simultaneously form exposed areas on said surface, said stops being movable relative to the carrier (4), and thus relative to the surface of the object, in a common direction of movement, **characterized in that** said stops are arranged in the form of a multi-stop assembly, one behind the other, in the direction of the relative movement, said stop openings (9, 10, 14, 15, 21, 26, 29, 32) representing geometrical surfaces such that each of the exposed areas on the surface of the object which are simultaneously formed by the partial beams (8) has a non-constant extent in the direction of movement, as seen transverse to the direction of relative movement.

2. Optical arrangement according to claim 1, **characterized in that** piezo-actuators are connected with the multi-stop assembly to move the stops relative to the carrier and, thus, relative to the surface of the object.

3. Optical arrangement according to claim 2, **characterized in that** the stops are movable relative to the carrier (4) and, thus, relative to the surface of the object, over a path length which corresponds to the distance between the stop openings in the direction of movement.

4. Optical arrangement according to any one of claims 1 to 3, **characterized in that** each of the stop openings (9, 20) has a rim formed of a straight line ($G_1$, $G_4$) and a parabola ($P_1$, $P_5$), said parabola ($P_1$, $P_5$), whose axis of symmetry ($SY_1$, $SY_4$) points in the direction of movement, connecting two points ($S_1$, $S_2$, $S_7$, $S_8$) on the straight line ($G_1$, $G_4$) extending perpendicular to the direction of movement.

5. Optical arrangement according to any one of claims 1 to 3, **characterized in that** each of the stop openings (10) has a rim formed of two parabolas ($P_2$, $P_3$), said parabolas ($P_2$, $P_3$), which have a common axis of symmetry ($SY_2$) pointing in the direction of movement, being convex in the direction of movement and in the opposite direction, and having common points of intersection ($S_3$, $S_4$) located on a straight line ($G_2$) extending perpendicular to the direction of movement.

6. Optical arrangement according to claim 4, **characterized in that** each of the stop openings (20) has at least one rectangular shading element ($R_1$, $R_2$) associated therewith, whose one side ($S_9$, $S_{10}$) coincides with the straight line ($G_4$) and whose opposite side ($S_{11}$, $S_{12}$) contacts the parabola ($P_5$) by its end points.

7. Optical arrangement according to claim 6, **characterized in that** edges of areas ($A_1$, $A_2$, $A_3$), which are left open by said at least one rectangular shading element ($R_1$, $R_2$), are situated at a common rim ($G_5$), said edges being in an orientation perpendicular to the direction of movement.

8. Optical arrangement according to one of claims 1 to 3, **characterized in that** each of the stop openings (15, 21) is a portion left open within a rectangular rim (16, 22) by a shading element (17, 23), wherein a pair of sides of the rim has sides (18, 19, 25, 25) extending perpendicular to the direction of movement.

9. Optical arrangement according to claim 8, **characterized in that** one of the sides (18, 19) extending perpendicular to the direction of movement coincides with a straight rim ($G_3$) of the shading element (17) whose other rim is a parabola ($P_4$) having an axis of symmetry ($SY_3$) in the direction of movement which connects two points ($S_5$, $S_6$) on the straight rim ($G_3$) with each other.

10. Optical arrangement according to claim 9, **characterized in that** the shading element (23) is formed of partial elements ($E_1$, $E_2$, $E_3$) remaining after at least one rectangular portion ($R_3$, $R_4$) is removed from a surface enclosed by a straight line ($G_6$) and a parabola ($P_6$), said parabola ($P_6$), whose axis of symmetry ($SY_5$) points in the direction of movement, connecting two points ($S_{13}$, $S_{14}$) on the straight line ($G_6$) extending perpendicular to the direction of movement,
that one side ($S_{15}$, $S_{16}$) of the rectangular portion ($R_3$, $R_4$) coincides with the straight line ($G_6$) and the opposite side ($S_{17}$, $S_{18}$) thereof contacts the parabola ($P_6$) by its end points,
and that the partial elements (E1, E2, E3) are positioned with their straight rims having an orientation perpendicular to the direction of movement to contact one of the sides (24, 25) of the rectangular rim (22) extending perpendicular to the direction of movement.

11. Optical arrangement according to any one of claims 1 to 3, **characterized in that** each of the stop openings comprises a rim formed by a right triangle (26), and one of the legs (27, 28), which are perpendicular to each other, points in the direction of movement.

12. Optical arrangement according to any one of claims 1 to 3, **characterized in that** each of the stop openings comprises a rim formed by an isosceles triangle (29), whose vertex formed by the equal sides points in the direction of movement.

**13.** Optical arrangement according to any one of claims 1 to 12, **characterized in that** adjusting slides (30, 31) are provided for adjusting the shape or magnitude of the stop.

**14.** Optical arrangement according to claim 1, **characterized in that** the means for shaping the cross section of the beam is a display screen.

**15.** Optical method for the manufacture of microlenses and microlens arrays by structuring a surface of an object on a carrier (4) by means of a beam (7) directed on said surface from a radiation source (1), with partial beams (8) being cut out from the cross-section of the beam (7) by means of stops having stop openings (9, 10, 14, 15, 20, 21, 26, 29, 31), said partial beams (8) simultaneously forming exposed areas on the surface of the object, said exposed areas being moved in one common direction of movement relative to the carrier and thus relative to the surface of the object, **characterized in that** the stops are arranged in a multi-stop assembly, one behind the other, in the direction of relative movement, and that exposed areas are simultaneously formed on the surface of the object by means of the partial beams, each of said exposed areas having a non-constant extent transversely to the direction of relative movement, as seen in the direction of movement.

**Revendications**

**1.** Dispositif de fabrication optique pour microlentilles et ensembles de microlentilles comportant une source de rayonnement (1) pour produire un faisceau de rayons (7) qui est dirigé sur une surface d'un objet à structurer par éclairage, sur un support (4), et comportant des diaphragmes dont les ouvertures (9, 10, 14, 15, 20, 21, 26, 29, 32) permettent d'éliminer des faisceaux de rayons partiels (8) de la section transversale du rayon (7) pour produire simultanément des zones d'éclairage sur la surface, les diaphragmes étant déplaçables par rapport au support (4) et donc par rapport à la surface de l'objet dans une direction de déplacement commune, **caractérisé en ce que** les diaphragmes sont disposés les uns derrière les autres sous la forme d'un diaphragme multiple dans la direction de déplacement du déplacement relatif, les ouvertures (9, 10, 14, 15, 20, 21, 26, 29, 32) des diaphragmes constituant des surfaces géométriques telles que chacune des zones d'éclairage, produites simultanément par les faisceaux de rayons partiels (8), présente, vue transversalement à la direction du déplacement relatif, une étendue non constante dans la direction de déplacement.

**2.** Dispositif de fabrication optique selon la revendication 1, **caractérisé en ce que** des piézo-actionneurs sont reliés au diaphragme multiple afin de déplacer les diaphragmes par rapport au support et donc par rapport à la surface de l'objet.

**3.** Dispositif de fabrication optique selon la revendication 2, **caractérisé en ce que** les diaphragmes sont déplaçables par rapport au support (4) et donc par rapport à la surface de l'objet sur une longueur qui correspond à l'écartement des ouvertures des diaphragmes dans la direction de déplacement.

**4.** Dispositif de fabrication optique selon l'une des revendications 1 à 3, **caractérisé en ce que** chacune des ouvertures (9, 20) des diaphragmes présente un bord formé d'une droite ($G_1$, $G_4$) et d'une parabole ($P_1$, $P_5$), les paraboles ($P_1$, $P_5$) dont l'axe de symétrie ($SY_1$, $SY_4$) est orienté dans la direction de déplacement, reliant entre eux deux points ($S_1$, $S_2$, $S_7$, $S_8$) sur les droites ($G_1$, $G_4$) s'étendant perpendiculairement à la direction de déplacement.

**5.** Dispositif de fabrication optique selon l'une des revendications 1 à 3, **caractérisé en ce que** chacune des ouvertures (10) des diaphragmes présente un bord formé de deux paraboles ($P_2$, $P_3$), les paraboles ($P_2$, $P_3$), qui présentent un axe de symétrie ($SY_2$) commun, orienté dans la direction du déplacement, étant réalisées convexes dans la direction de déplacement et la direction opposée, et présentant des points d'intersection ($S_3$, $S_4$) communs situés sur une droite ($G_2$) s'étendant perpendiculairement à la direction de déplacement.

**6.** Dispositif de fabrication selon la revendication 4, **caractérisé en ce qu'**à chacune des ouvertures (20) des diaphragmes est associé au moins un élément rectangulaire ($R_1$, $R_2$) d'obscurcissement dont un côté ($S_G$, $S_{10}$) coïncide avec la droite ($G_4$) et dont le côté opposé ($S_{11}$, $S_{12}$) touche, par ses points d'extrémité, la parabole ($P_5$).

**7.** Dispositif de fabrication optique selon la revendication 6, **caractérisé en ce que** des zones ($A_1$, $A_2$, $A_3$) dégagées par le ou les éléments rectangulaires ($R_1$, $R_2$) d'obscurcissement, sont placées, par leurs bords dirigés perpendiculairement à la direction de déplacement, sur un bord commun (Gs).

**8.** Dispositif de fabrication optique selon l'une des revendications 1 à 3, **caractérisé en ce que** chacune des ouvertures (15, 21) des diaphragmes est une portion laissée libre dans une bordure rectangulaire (16, 22) d'un élément d'obscurcissement (17, 23), une paire de côtés de la bordure présentant des côtés (18, 19, 25, 25) s'étendant perpendiculairement à la direction de déplacement.

**9.** Dispositif de fabrication optique selon la revendication 8, **caractérisé en ce que** l'un des côtés (18, 19), s'étendant perpendiculairement à la direction de déplacement, coïncide avec un bord (3, $G_3$) de l'élément d'obscurcissement (17), dont le bord restant est une parabole ($P_4$) avec un axe de symétrie ($SY_3$) dans la direction de déplacement, qui relie entre eux deux points ($S_5$, $S_6$) sur le bord droit ($G_3$).

**10.** Dispositif de fabrication optique selon la revendication 9, **caractérisé en ce que** l'élément d'obscurcissement (23) est constitué d'éléments partiels ($E_1$, $E_2$, $E_3$) qui subsistent lorsque est enlevée au moins une portion rectangulaire ($R_3$, $R_4$) d'une surface qui est entourée par une droite ($G_6$) et une parabole ($P_6$), la parabole ($P_6$), dont l'axe de symétrie ($SY_5$) est dirigé dans la direction de déplacement, reliant entre eux ($S_{13}$, $S_{14}$) sur la droite ($G_6$) s'étendant perpendiculairement à la direction de déplacement, un côté ($S_{15}$, $S_{16}$) de la portion rectangulaire ($R_3$, $R_4$) coïncidant avec la droite ($G_6$) et le côté opposé ($S_{17}$, $S_{18}$) étant en contact, par ses points d'extrémité, avec la parabole ($P_6$),
et **en ce que** les éléments partiels ($E_1$, $E_2$, $E_3$) sont placés, par leurs bords droits, dirigés perpendiculairement à la direction de déplacement, sur l'un des côtés (24, 25), s'étendant perpendiculairement à la direction de déplacement, de la bordure rectangulaire (22).

**11.** Dispositif de fabrication optique selon l'une des revendications 1 à 3, **caractérisé en ce que** chacune des ouvertures des diaphragmes présente un bord formé par un triangle rectangle (26) et l'un des côtés (27, 28), orienté perpendiculairement l'un à l'autre, est dirigé dans la direction de déplacement.

**12.** Dispositif de fabrication optique selon l'une des revendications 1 à 3, **caractérisé en ce que** chacune des ouvertures des diaphragmes présente un bord formé dans une forme triangulaire isocèle (29) qui est dirigée dans la direction de déplacement par son sommet formé par les côtés égaux.

**13.** Dispositif de fabrication optique selon l'une des revendications 1 à 12, **caractérisé en ce que** pour régler la forme ou la taille du diaphragme, sont prévus des coulisseaux de réglage (30, 31).

**14.** Dispositif de fabrication optique selon la revendication 1, **caractérisé en ce que** le dispositif pour le formage de la section transversale du faisceau de rayons est un écran.

**15.** Procédé de fabrication optique pour microlentilles et ensembles de microlentilles par structuration d'un surface d'un objet sur un support (4), au moyen d'un faisceau de rayons (7) dirigé sur la surface, provenant d'une source de rayonnement (1), de la section transversale du faisceau de rayons (7) étant éliminés, au moyen de diaphragmes avec des ouvertures (9, 10, 14, 20, 21, 26, 29, 31), des faisceaux de rayons partiels (8) qui produisent en même temps des zones d'éclairage sur la surface de l'objet, ces zones d'éclairage étant déplacées par rapport au support et donc par rapport à la surface de l'objet dans une direction de déplacement commune, **caractérisé en ce que** les diaphragmes sont réalisés l'un derrière l'autre dans un diaphragme multiple, dans la direction du déplacement relatif, et **en ce qu'**au moyen des faisceaux de rayons partiels sont produites en même temps, sur la surface de l'objet, des zones d'éclairage dont chacune vue transversalement à la direction du déplacement relatif, présente une étendue non constante dans la direction de déplacement.

Fig. 1

Fig. 2

Fig. 3a

Fig. 3b

Fig. 3c

Fig. 4a

Fig. 4b

Fig. 4c

Fig. 5a

Fig. 5b

Fig. 5c.

Fig. 6a

Fig. 6b

Fig. 6c

Fig. 6d

Fig. 7d

V

24

21

22

23

25

Fig. 7a

Fig. 7b

Fig. 7c

V

26

27

28

Fig. 8a

Fig. 8b

Fig. 8c

Fig. 9a

Fig. 9b

Fig. 9c

Fig. 10a

Fig. 10b

Fig. 11

Fig. 12

Z-Z

Fig. 13

Fig. 14

2    Fig. 15a    5

Fig. 15b

2    Fig. 16a    5

Fig. 16b